# EUROPEAN PATENT APPLICATION

(11) **EP 4 485 542 A1**
(43) Date of publication of application: **01.01.2025**
(21) Application number: 23216200.8
(22) Date of filing: 13.12.2023
(51) Int. Cl.: H01L 29/06, H01L 29/08, H01L 29/32, H01L 29/36, H01L 29/45, H01L 29/775

(54) **TRANSISTORS WITH ANTIMONY AND PHOSPHORUS DOPED EPITAXIAL SOURCE/DRAIN LAYERS**

(30) Priority: 30.06.2023 US 202318345931
(71) Applicant: Intel Corporation, Santa Clara, CA 95054 (US)
(72) Inventor: MURTHY, Anand S., Portland 97229 (US); PANDYA, Shishir, Hillsboro 97124 (US); KALLY, James, Hillsboro 97124 (US); EHLERT, Robert, Portland 97229 (US); GHANI, Tahir, Portland 97229 (US)
(74) Representative: 2SPL Patentanwälte PartG mbB

(57) **Abstract**

In some implementations, a device (200) may include a channel material (210). In addition, the device may include a contact metal (222). The device may include a first layer (218) between the channel material and the contact metal, the first layer having antimony and silicon. Moreover, the device may include a second layer (220) between the contact metal and the first layer, the second layer having phosphorus and silicon.

## Description

### BACKGROUND

In semiconductor devices, as transistor dimensions scale, the area forming the contact between a metal and the source/drain epitaxial region gets smaller and the contact resistance goes up. Contact resistance, as opposed to the intrinsic resistance of a material, refers to the resistance attributable to electricity flowing over an interface between materials, such as between metal and silicide, for example. The excess power consumption attributable to contact resistance can be one of the main factors limiting increased computer processor performance. This resistance directly impacts the performance of the transistor and determines the maximum clock frequency achievable in devices utilizing these transistors.

### BRIEF DESCRIPTION OF DRAWINGS

FIG. 1 is a perspective view of an example gate-all-around field effect transistor (GAAFET).
FIG. 2 illustrates an example N-type metal-oxide-semiconductor (NMOS) device having a FinFET architecture.
FIG. 3 illustrates a cross section of an example NMOS device having a FinFET architecture.
FIG.4 illustrates an example method for forming transistors with antimony and phosphorus doped epitaxial source/drain layers.
FIG. 5 provides a schematic illustration of a cross-sectional view of an example integrated circuit device.
FIG. 6 is a top view of an example wafer and dies that may be included in a microelectronic assembly.
FIG. 7 is a cross-sectional side view of an example integrated circuit device.
FIGS. 8A-8D are simplified perspective views of example planar, FinFET, gate-all-around, and stacked gate-all-around transistors.
FIG. 9 is a cross-sectional side view of an example integrated circuit device assembly.
FIG. 10 is a block diagram of an example electrical device.

### DETAILED DESCRIPTION

As transistors scale to smaller dimensions, maintaining a suitable contact resistivity of a source/drain (where "source/drain" may refer to either or both of a source or drain of a transistor) becomes a challenge. As transistors are scaled, superior short channel effect (SCE) with abrupt junctions without degradation of tip resistance is important.

A source/drain region of a transistor may include a nucleation layer that is coupled to the channel material and a main layer that is coupled to the nucleation layer. The main layer may be coupled to the metal contact for the source/drain.

Phosphorus may be present in the main layer of the source/drain region of an n-type metal-oxide-semiconductor (NMOS) (e.g., the main layer may comprise a phosphorus doped semiconductor, such as phosphorus doped silicon). Phosphorus may be beneficial as it exhibits high conductance and may help lower the overall contact resistance of the source/drain. However, phosphorus is susceptible to diffusion into the channel of the transistor, which increases the leakage and degrades the short channel effect of the transistor.

In some integrated circuits, a nucleation layer of a source/drain of a transistor may comprise arsenic to alleviate issues with phosphorus diffusion into the channel. However, arsenic is highly toxic and therefore difficult and expensive to handle. Moreover, arsenic doped silicon still suffers from transient enhanced diffusion effects and results in a higher resistance in the nucleation layer, especially so if the arsenic concentration is high (e.g., over 5E20 atoms/cm3).

In various embodiments of the present disclosure, a highly conformal and selective epitaxial antimony doped silicon nucleation layer is provided. In various embodiments, the nucleation layer may include silicon doped with antimony, or silicon co-doped with antimony and phosphorus. Various embodiments may also include a very heavily phosphorus doped silicon main layer. For example, the main layer may have a higher concentration of phosphorus than the nucleation layer. Various embodiments may include NMOS transistors using dual layers of insitu selective antimony and phosphorus doped epitaxial source/drain layers.

Use of antimony doped silicon in the nucleation layer may result in similar (or better) blocking of the phosphorus diffusion relative to arsenic doped silicon while achieving superior conductivity. For example, various embodiments may result in low resistivity in the source/drain contact (e.g., less than 0.8 mOhm-cm at a concentration of ~1E21 antimony atoms/cm³). The antimony doped silicon may also improve transistor short channel effects.

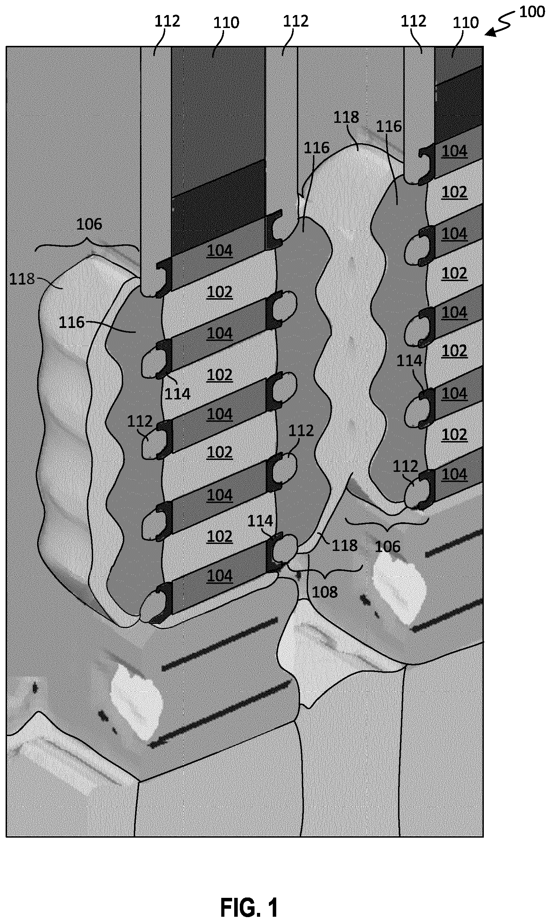

FIG. 1 illustrates a portion of an example integrated circuit 100 including NMOS transistors having a gate-all-around (GAA) architecture. The architecture depicted includes transistors having nanoribbons 102 (e.g., silicon nanoribbons) in between layers of silicon germanium 104 (in various embodiments, the silicon germanium may be released at a later phase of the processing). In various embodiments, the stack of nanoribbons 102 and layers of silicon germanium 104 may be epitaxially grown on a substrate (e.g., a silicon substrate). The nanoribbons 102 may couple a source region 106 of a transistor to a drain region 108 and may function as the channel of the transistor.

At the particular phase shown in FIG. 1, the architecture includes a dummy gate 110 (e.g., comprising polysilicon). The dummy gate may be formed to enable downstream processing and may be removed (e.g., etched out) later in the manufacturing process when the actual gate material is formed.

The architecture may also include a variety of spacers that may isolate various components and help minimize capacitance in the gate-all-around architecture. For example, the spacers may include spacers 112 as well as inner spacer or cavity spacers 114.

A source region 106 or drain region 108 may include a nucleation layer 116 and a main layer 118. In various embodiments, the nucleation layer 116 is epitaxial and is in between and/or in contact with nanoribbons 102 and main layer 118. In the embodiment depicted, the nucleation layer 116 buffers the main layer 118 from directly contacting the channel material (e.g., nanoribbons 102). In various embodiments, the nucleation layer may be grown with high selectivity. For example, the nucleation layer is only grown on the semiconductor material (e.g., nanoribbons 102) and is not grown on the dielectric surfaces (e.g., spacers 112 or cavity spacers 114), as spurious growth on the dielectric surfaces could lead to undesired shorts. The contour of the nucleation layer may be due to the selectivity resulting in no growth on the spacers 112 (thus lateral growth is inhibited near the spacers 112).

In various embodiments, the nucleation layer 116 comprises silicon and antimony (e.g., the nucleation layer may be formed with antimony doped silicon). In some embodiments, the nucleation layer 116 comprises silicon, antimony, and phosphorus (e.g., the nucleation layer 116 may be formed with silicon co-doped with antimony and phosphorus).

In various embodiments, the antimony concentration in the nucleation layer 116 may be within the range of 3E20 to 2E21 atoms/cm3. In some embodiments, if the antimony concentration is lower than this, there is a possibility that the nucleation layer may not provide sufficient suppression of the phosphorus diffusion and a sufficient short channel effect, while if the antimony is higher than this, the resistivity may increase above a desired level. In some embodiments, the antimony concentration is roughly 5E20 atoms/cm³, resulting in a good balance between diffusion suppression and resistivity.

The main layer 118 may be in contact with and/or be between the nucleation layer 116 and a contact metal (not shown) that is the contact for the source or drain (e.g., the contact metal may be formed above and/or the side of the source region 106 or drain region 108). The main layer 118 may comprise silicon and phosphorus (e.g., the main layer may be formed with silicon doped with phosphorus). In various embodiments, the antimony in the nucleation layer 116 suppresses diffusion of phosphorus from the main layer 118 into the channel (e.g., nanoribbons 102).

In some embodiments, one or more intermediate contact materials may be formed between the main layer 118 and the drain/source contact metal. For example, the intermediate contact material may comprise one or more conductive materials, such as titanium, nickel, or platinum. In various embodiments, an intermediate contact material may interact with silicon of the main layer 118 to form a silicide (e.g., at the top or other outer surface of the main layer 118). In various embodiments, a thin metal nitride (e.g., titanium nitride) may also (or alternatively) be deposited as an intermediate contact material. The source/drain contact metal (e.g., titanium, tungsten, cobalt, copper, aluminum, ruthenium, alloys of any of these, or other conductive material) may then be formed over the intermediate contact material.

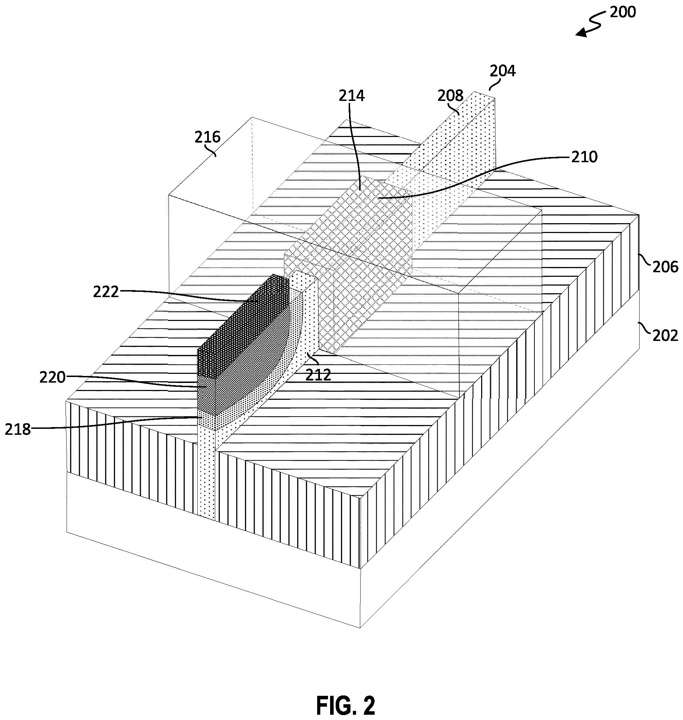

FIG. 2 illustrates an NMOS device 200 having a FinFET architecture. As shown, device 200 includes substrate 202, fin 204, insulator 206, drain region 208, semiconductor region 210, source region 212, gate dielectric 214, gate region 216, and contact metal 222. The source region 212 comprises a portion of fin 204 (e.g., a semiconductor material), nucleation layer 218, and main layer 220. While shown as including a single fin 204 and gate region 216, in some embodiments, device 200 may include multiple fins 204 and/or gate regions 216.

In various embodiments, substrate 202 comprises an undoped semiconductor, such as Ge, Si, SiGe, InGaAs, or AlSb. In some embodiments, substrate 202 is composed of one or more semiconductor material layers on top of another semiconductor material such as silicon. In some embodiments, insulator 206 is composed of a buried oxide layer that is adjacent to fin 204.

The material of the substrate 202 may also be used to form fin 204, which may comprise drain region 208, semiconductor region 210, and source region 212. In other embodiments, fin 204 may be formed separately from substrate 202 and may contain one or more different semiconductor materials.

When device 200 is in an active mode, semiconductor region 210 may serve as a channel between source region 212 and drain region 208, which are located on opposite sides of semiconductor region 210. In some embodiments, source region 212 and drain region 208 comprise n-doped variants of the same semiconductor material as semiconductor region 210.

The source region 212 comprises a nucleation layer 218 and a main layer 220. Nucleation layer 218 may represent a substantially conformal thin film epitaxially formed on a surface within source region 212. In some embodiments, the nucleation layer may be formed on a recess created within source region 212.

In various embodiments. Main layer 220 may be formed on and contact the nucleation layer 218. In some embodiments, main layer 220 may be between nucleation layer 218 and contact metal 222. In some embodiments, main layer 220 may fill a portion of recess formed in source region 212. While shown as being curved in shape, in some embodiments, nucleation layer 218 and/or main layer 220 may include one or more planar surfaces.

Contact metal 222 may be formed on main layer 220 and may contact the main layer 220.

In various embodiments, the nucleation layer 218, main layer 220, and the contact metal 222 may respectively comprise any of the materials described above with respect to nucleation layer 116, main layer 118, and the previously described contact metal. In various embodiments, an intermediate contact material may be formed between the contact metal 222 and the main layer 220 (e.g., similar to that described above).

While shown as being present in source region 212, a similar nucleation layer 218, main layer 220, and contact metal 222 may be present in drain region 208.

Gate region 216, along with gate dielectric 214, may form a gate stack on semiconductor region 210. Gate region 216 may comprise a metal coupled with interconnects (not shown) to provide a voltage proximate to semiconductor region 210 to place device 200 into an active mode. In some embodiments, gate dielectric 214 may include oxides and/or nitrides.

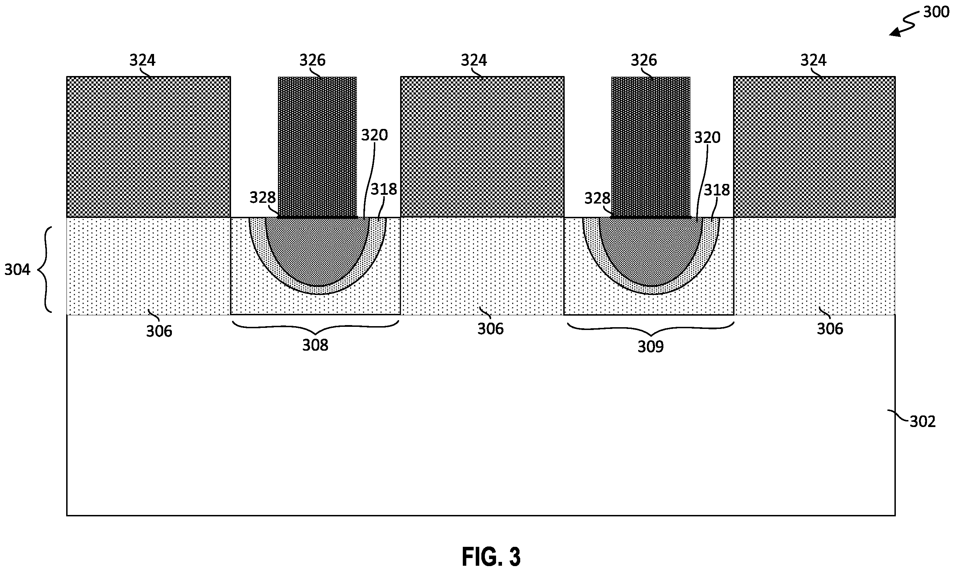

FIG. 3 illustrates a cross section of an example NMOS device 300 having a FinFET architecture. Device 300 includes substrate 302, fin 304, semiconductor regions 306, source region 308, drain region 309, gate stacks 324, and contact metals 326. Device 300 may comprise a tri-gate FinFET. In various embodiments, device 300 may include one or more additional layers that are not depicted.

Device 300 may have nucleation layers 318 formed adjacent (e.g., on) recessed portions within the fin. Nucleation layers 318 may have any suitable characteristics of other nucleation layers described herein (e.g., 116 or 218). In some embodiments, nucleation layers 318 (or 116 or 218) are substantially conformal (e.g., in depth and/or width), with thickness of between 2 and 7 nm. In some embodiments, nucleation layers 318 are epitaxially formed.

Device 300 may also include main layers 320 formed within recessed portions of the fin 304. A main layer 320 is formed adjacent (e.g., on) a nucleation layer 318. The main layer 320 may have any suitable characteristics of other main layers (e.g., 118 or 220) or source/drain materials described herein.

Device 300 may also include gate stacks 324. In some embodiments, gate regions may be subjected to processing steps to form gate stacks 324. In some embodiments, gate stacks 324 are formed through a gate replacement process to form separate spacer and metal regions (not shown).

Device 300 may include contact metals 326 formed above (e.g., on) nucleation layers 318. In some embodiments, a contact metal may have any suitable characteristics of other contact metals described herein.

Device 300 may also include silicide layers 328 formed between main layers 320 and contact metals 326. In some embodiments, silicidation processes such as annealing or sintering may form a metal-silicon alloy at the junction of main layers 320 and contact metals 326. In some embodiments, silicide layers 328 may comprise a titanium silicon alloy, which has a significantly lower resistivity than a polysilicon.

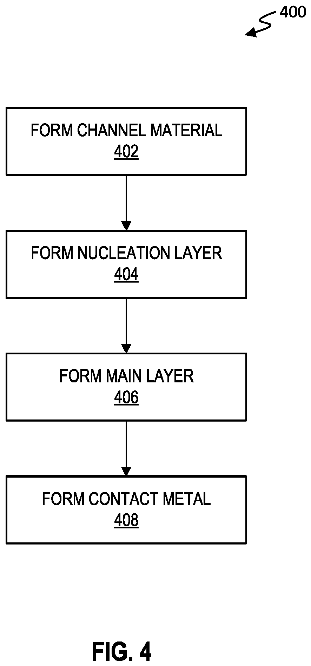

FIG. 4 illustrates an example process 400 for forming transistors with antimony and phosphorus doped epitaxial source/drain layers.

At 402, a channel material is formed. The channel material may comprise a semiconductor material through which current may flow. In some embodiments, the channel material may form one or more nanoribbons, nanowires, or nanosheets. In one embodiment, the channel material may comprise portions of one or more fins formed above a substrate.

At 404, a nucleation layer is formed. At least a portion of the nucleation layer may be formed adjacent to a portion of the channel material. For example, the nucleation layer may contact all or a portion of one edge of the channel material.

In various embodiments, the nucleation layer may comprise antimony. In various embodiments, the antimony may be applied using a suitable deposition technique, such as chemical vapor deposition. In various embodiments, the deposition may be performed at a temperature that is within the range of 600 to 750 degrees Celsius. In one embodiment, the deposition is performed at approximately 675 degrees.

In various embodiments, the nucleation layer may comprise antimony doped silicon. In some embodiments, the deposition may include application of any suitable gases comprising antimony and silicon. For example, the deposition materials may include a precursor comprising antimony (e.g., trimethyl antimony, triethyl antimony, or antimony pentachloride) and a precursor comprising silicon (e.g., dichlorosilane or silane). In some embodiments, the deposition materials may also include an additional precursor gas (e.g., hydrogen chloride) to provide the desired selectivity (e.g., such that epitaxial growth only occurs on the exposed channel material, e.g., nanoribbons 102 or portion of fin 204). In embodiments where the nucleation layer is co-doped with antimony and phosphorus, the deposition materials may also include a precursor gas comprising phosphorus (e.g., phosphene). Additionally, the deposition materials may include a carrier gas (e.g., hydrogen).

At 406, a main layer is formed. At least a portion of the main layer may be formed adjacent to a portion of the nucleation layer. For example, the nucleation layer may contact all or a portion of one edge of the channel material. In some embodiments, the main layer may be formed adjacent an entire surface (e.g., a top surface, a side surface, etc.) of the nucleation layer.

In various embodiments, the main layer may comprise phosphorus doped silicon. In some embodiments, the deposition may include application of any suitable gases comprising phosphorus and silicon. For example, the deposition materials may include a precursor comprising phosphorus (e.g., phosphene) and a precursor comprising silicon (e.g., dichlorosilane or silane).

At 408, a contact metal is formed. The contact metal may be formed adjacent the main layer. In some embodiments, the contact metal is formed over the main layer and an intermediate contact material is formed between the main layer and the contact metal.

Although FIG. 4 shows example blocks of process 400, in some implementations, process 400 may include additional blocks, fewer blocks, different blocks, or differently arranged blocks than those depicted in Fig. 4. Additionally, or alternatively, two or more of the blocks of process 400 may be performed in parallel.

Although the embodiments depicted are directed towards GAA nanoribbon and FinFET architectures, the various embodiments described herein may also be utilized with other suitable transistors comprising nucleation layers, such as complementary FETs (C-FETs) or other suitable transistors.

Any suitable characteristics of particular device components (e.g., contact metals, source/drain regions, source/drain main layers, source/drain nucleation layers, etc.) described with respect to one of the embodiments herein may also be applicable to the other embodiments described herein (including the embodiments described below).

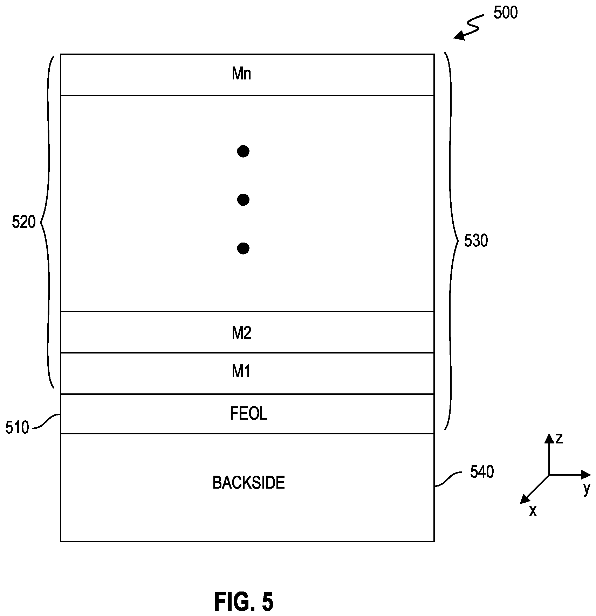

FIG. 5 provides a schematic illustration of a cross-sectional view of an example integrated circuit device (e.g., a chip) 500, according to some embodiments of the present disclosure. The IC device 500 may include one or more transistors comprising antimony and phosphorus doped epitaxial source/drain layers as described herein.

Embodiments described herein may be directed to front-end-of-line (FEOL) semiconductor processing and structures. FEOL is the first portion of integrated circuit (IC) fabrication where the individual devices (e.g., transistors, capacitors, resistors, etc.) are patterned in the semiconductor substrate or layer. FEOL generally covers everything up to (but not including) the deposition of metal interconnect layers. Following the last FEOL operation, the result is typically a wafer with isolated transistors (e.g., without any wires).

Embodiments described herein may be directed to back end of line (BEOL) semiconductor processing and structures. BEOL is the second portion of IC fabrication where the individual devices (e.g., transistors, capacitors, resistors, etc.) are interconnected with wiring on the wafer, e.g., the metallization layer or layers. BEOL may include contacts, insulating layers (dielectrics), metal levels, and bonding sites for chip-to-package connections. In the BEOL part of the fabrication stage contacts (pads), interconnect wires, vias and dielectric structures are formed.

Embodiments described herein may be applicable to FEOL processing and structures, BEOL processing and structures, or both FEOL and BEOL processing and structures. In particular, although an exemplary processing scheme may be illustrated using a FEOL processing scenario, such approaches may also be applicable to BEOL processing. Likewise, although an exemplary processing scheme may be illustrated using a BEOL processing scenario, such approaches may also be applicable to FEOL processing.

As shown in FIG. 5, the IC device 500 may include a front side 530 comprising a FEOL portion 510 that includes various logic layers, circuits, and devices to drive and control a logic IC. These circuits and devices may be configured for any number of functions, such as logic or compute transistors, input/output (I/O) transistors, access or switching transistors, and/or radio frequency (RF) transistors, to name a few examples. According to some embodiments, in addition to these devices and circuits, FEOL portion 510 may include, for example, one or more other layers or structures associated with the semiconductor devices and circuits. For example, the FEOL portion 510 can also include a substrate and one or more dielectric layers that surround active and/or conductive portions of the devices and circuits. The FEOL portion may also include one or more conductive contacts that provide electrical contact to transistor elements such as gate structures, drain regions, or source regions. The FEOL portion may also include local interconnect (e.g., vias or lines) that connect contacts to interconnect features within the BEOL portion 520.

The front side 530 of the IC device 500 also includes a BEOL portion 520 including various metal interconnect layers (e.g., metal 9 through metal n, where n is any suitable integer). Various metal layers of the BEOL portion 520 may be used to interconnect the various inputs and outputs of the FEOL portion 510.

Generally speaking, each of the metal layers of the BEOL portion 520, e.g., each of the layers M1-Mn shown in FIG. 5, may include a via portion and a trench/interconnect portion. Typically, the trench portion of a metal layer is above the via portion, but, in other embodiments, a trench portion may be provided below a via portion of any given metal layer of the BEOL portion 520. The trench portion of a metal layer may be configured for transferring signals and power along metal lines (also sometimes referred to as "trenches") extending in the x-y plane (e.g., in the x or y directions), while the via portion of a metal layer may be configured for transferring signals and power through metal vias extending in the z-direction, e.g., to any of the adjacent metal layers above or below. Accordingly, vias connect metal structures (e.g., metal lines or vias) from one metal layer to metal structures of an adjacent metal layer. While referred to as "metal" layers, various layers of the BEOL portion 520, e.g., layers M1-Mn shown in FIG. 5, may include certain patterns of conductive metals, e.g., copper (Cu) or aluminum (Al), or metal alloys, or more generally, patterns of an electrically conductive material, formed in an insulating medium such as an interlayer dielectric (ILD). The insulating medium may include any suitable ILD materials such as silicon oxide, silicon nitride, aluminum oxide, and/or silicon oxynitride. In various embodiments, any one or more of these layers may additionally include active devices (e.g., transistors, diodes) and/or passive devices (e.g., capacitors, resistors, inductors).

The IC device 500 may also include a backside 540. For example, the backside 540 may formed on the opposite side of a wafer from the front side 530. In various embodiments, the backside 540 may include any suitable elements to assist operation of the IC device 500. For example, the backside 540 may include various metal layers to deliver power to logic of the FEOL portion 510. In some embodiments, transistors or other circuit elements may be formed on the backside 540 of the IC device 500.

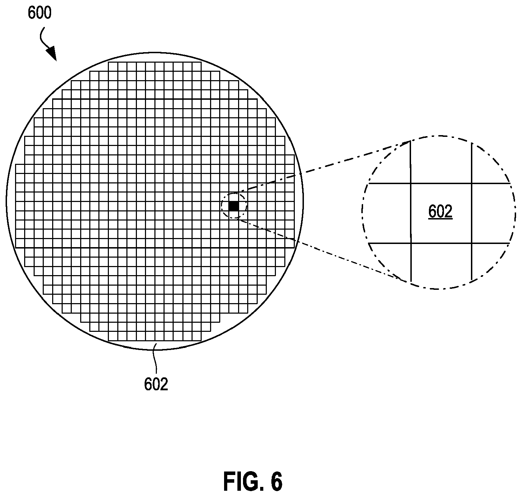

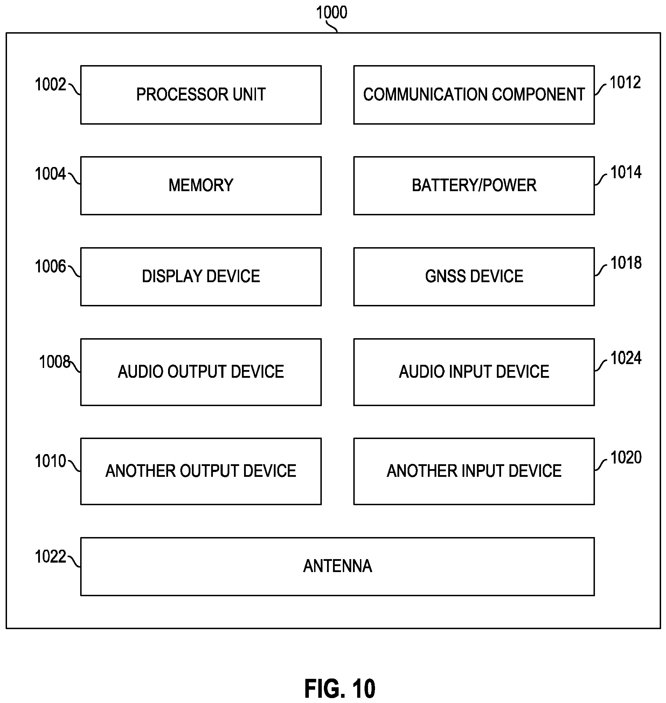

FIG. 6 is a top view of a wafer 600 and dies 602 wherein individual dies may include one or more transistors comprising antimony and phosphorus doped epitaxial source/drain layers as described herein. The wafer 600 may be composed of semiconductor material and may include one or more dies 602 having integrated circuit structures formed on a surface of the wafer 600. The individual dies 602 may be a repeating unit of an integrated circuit product that includes any suitable integrated circuit. After the fabrication of the semiconductor product is complete, the wafer 600 may undergo a singulation process in which the dies 602 are separated from one another to provide discrete "chips" of the integrated circuit product. The die 602 may include one or more transistors supporting circuitry to route electrical signals to the transistors, passive components (e.g., signal traces, resistors, capacitors, or inductors), and/or any other integrated circuit components. In some embodiments, the wafer 600 or the die 602 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 602. For example, a memory array formed by multiple memory devices may be formed on a same die 602 as a processor unit (e.g., the processor unit 1002 of FIG. 10) or other logic that is configured to store information in the memory devices or execute instructions stored in the memory array. Various ones of the microelectronic assemblies disclosed herein may be manufactured using a die-to-wafer assembly technique in which some dies are attached to a wafer 600 that include other dies, and the wafer 600 is subsequently singulated.

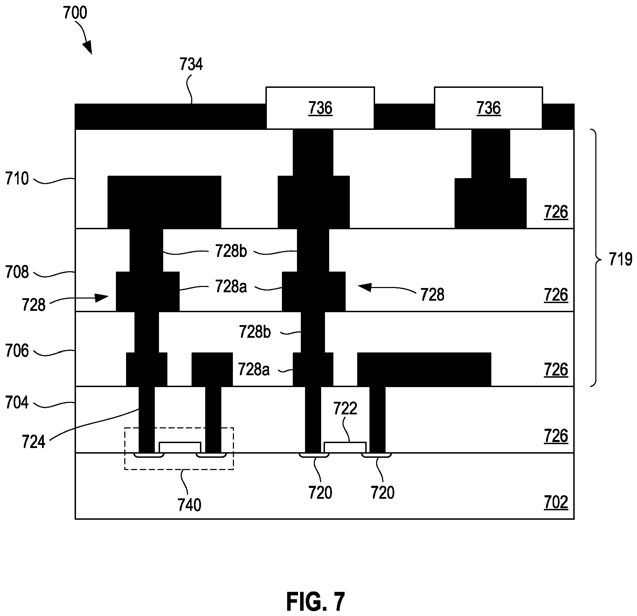

FIG. 7 is a cross-sectional side view of an integrated circuit device 700 that may include one or more transistors comprising antimony and phosphorus doped epitaxial source/drain layers as described herein. One or more of the integrated circuit devices 700 may be included in one or more dies 602 (FIG. 6). The integrated circuit device 700 may be formed on a die substrate 702 (e.g., the wafer 600 of FIG. 6) and may be included in a die (e.g., the die 602 of FIG. 6). The die substrate 702 may be a semiconductor substrate composed of semiconductor material systems including, for example, n-type or p-type materials systems (or a combination of both). The die substrate 702 may include, for example, a crystalline substrate formed using a bulk silicon or a silicon-on-insulator (SOI) substructure. In some embodiments, the die substrate 702 may be formed using alternative materials, which may or may not be combined with silicon, that include, but are not limited to, germanium, indium antimonide, lead telluride, indium arsenide, indium phosphide, gallium arsenide, or gallium antimonide. Further materials classified as group II-VI, III-V, or IV may also be used to form the die substrate 702. Although a few examples of materials from which the die substrate 702 may be formed are described here, any material that may serve as a foundation for an integrated circuit device 700 may be used. The die substrate 702 may be part of a singulated die (e.g., the dies 602 of FIG. 6) or a wafer (e.g., the wafer 600 of FIG. 6).

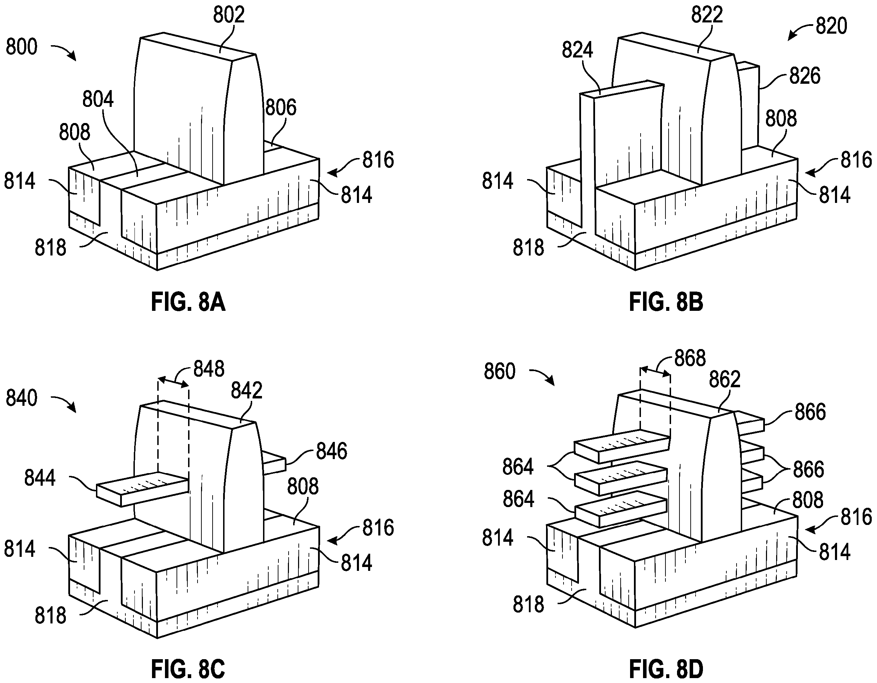

The integrated circuit device 700 may include one or more device layers 704 disposed on the die substrate 702. The device layer 704 may include features of one or more transistors 740 (e.g., metal oxide semiconductor field-effect transistors (MOSFETs)) formed on the die substrate 702. The transistors 740 may include, for example, one or more source and/or drain (S/D) regions 720, a gate 722 to control current flow between the S/D regions 720, and one or more S/D contacts 724 to route electrical signals to/from the S/D regions 720. The transistors 740 may include additional features not depicted for the sake of clarity, such as device isolation regions, gate contacts, and the like. The transistors 740 are not limited to the type and configuration depicted in FIG. 7 and may include a wide variety of other types and configurations such as, for example, planar transistors, non-planar transistors, or a combination of both. Non-planar transistors may include FinFET transistors, such as double-gate transistors or tri-gate transistors, and wrap-around or all-around gate transistors, such as nanoribbon, nanosheet, or nanowire transistors. Examples of non-planar transistors will be described in connection with FIGs. 8A-8D.

A transistor 740 may include a gate 722 formed of at least two layers, a gate dielectric and a gate electrode. The gate dielectric may include one layer or a stack of layers. The one or more layers may include silicon oxide, silicon dioxide, silicon carbide, and/or a high-k dielectric material.

The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric to improve its quality when a high-k material is used.

The gate electrode may be formed on the gate dielectric and may include at least one p-type work function metal or n-type work function metal, depending on whether the transistor 740 is to be a p-type metal oxide semiconductor (PMOS) or an n-type metal oxide semiconductor (NMOS) transistor. In some implementations, the gate electrode may consist of or comprise a stack of two or more metal layers, where one or more metal layers are work function metal layers and at least one metal layer is a fill metal layer. Further metal layers may be included for other purposes, such as a barrier layer.

For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, when viewed as a cross-section of the transistor 740 along the source-channel-drain direction, the gate electrode may consist of or comprise a U-shaped structure that includes a bottom portion substantially parallel to the surface of the die substrate 702 and two sidewall portions that are substantially perpendicular to the top surface of the die substrate 702. In other embodiments, at least one of the metal layers that form the gate electrode may simply be a planar layer that is substantially parallel to the top surface of the die substrate 702 and does not include sidewall portions substantially perpendicular to the top surface of the die substrate 702. In other embodiments, the gate electrode may consist of or comprise a combination of U-shaped structures and planar, non-U-shaped structures. For example, the gate electrode may consist of or comprise one or more U-shaped metal layers formed atop one or more planar, non-U-shaped layers.

In some embodiments, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of spacer pairs may be used; for instance, two pairs, three pairs, or four pairs of sidewall spacers may be formed on opposing sides of the gate stack.

The S/D regions 720 may be formed within the die substrate 702 adjacent to the gate 722 of individual transistors 740. The S/D regions 720 may be formed using an implantation/diffusion process or an etching/deposition process, for example. In the former process, dopants such as boron, aluminum, antimony, phosphorus, or arsenic may be ion-implanted into the die substrate 702 to form the S/D regions 720. An annealing process that activates the dopants and causes them to diffuse farther into the die substrate 702 may follow the ion-implantation process. In the latter process, the die substrate 702 may first be etched to form recesses at the locations of the S/D regions 720. An epitaxial deposition process may then be carried out to fill the recesses with material that is used to fabricate the S/D regions 720. In some implementations, the S/D regions 720 may be fabricated using a silicon alloy such as silicon germanium or silicon carbide. In some embodiments, the epitaxially deposited silicon alloy may be doped in situ with dopants such as boron, arsenic, or phosphorus. In some embodiments, the S/D regions 720 may be formed using one or more alternate semiconductor materials such as germanium or a group III-V material or alloy. In further embodiments, one or more layers of metal and/or metal alloys may be used to form the S/D regions 720.

Electrical signals, such as power and/or input/output (I/O) signals, may be routed to and/or from the devices (e.g., transistors 740) of the device layer 704 through one or more interconnect layers disposed on the device layer 704 (illustrated in FIG. 7 as interconnect layers 706-710). For example, electrically conductive features of the device layer 704 (e.g., the gate 722 and the S/D contacts 724) may be electrically coupled with the interconnect structures 728 of the interconnect layers 706-710. The one or more interconnect layers 706-710 may form a metallization stack (also referred to as an "ILD stack") 719 of the integrated circuit device 700.

The interconnect structures 728 (e.g., lines) may be arranged within the interconnect layers 706-710 to route electrical signals according to a wide variety of designs; in particular, the arrangement is not limited to the particular configuration of interconnect structures 728 depicted in FIG. 7. Although a particular number of interconnect layers 706-710 is depicted in FIG. 7, embodiments of the present disclosure include integrated circuit devices having more or fewer interconnect layers than depicted.

In some embodiments, the interconnect structures 728 may include lines 728a and/or vias 728b filled with an electrically conductive material such as a metal. The lines 728a may be arranged to route electrical signals in a direction of a plane that is substantially parallel with a surface of the die substrate 702 upon which the device layer 704 is formed. For example, the lines 728a may route electrical signals in a direction in and out of the page and/or in a direction across the page. The vias 728b may be arranged to route electrical signals in a direction of a plane that is substantially perpendicular to the surface of the die substrate 702 upon which the device layer 704 is formed. In some embodiments, the vias 728b may electrically couple lines 728a of different interconnect layers 706-710 together.

The interconnect layers 706-710 may include a dielectric material 726 disposed between the interconnect structures 728, as shown in FIG. 7. In some embodiments, dielectric material 726 disposed between the interconnect structures 728 in different ones of the interconnect layers 706-710 may have different compositions; in other embodiments, the composition of the dielectric material 726 between different interconnect layers 706-710 may be the same. The device layer 704 may include a dielectric material 726 disposed between the transistors 740 and a bottom layer of the metallization stack as well. The dielectric material 726 included in the device layer 704 may have a different composition than the dielectric material 726 included in the interconnect layers 706-710; in other embodiments, the composition of the dielectric material 726 in the device layer 704 may be the same as a dielectric material 726 included in any one of the interconnect layers 706-710.

A first interconnect layer 706 (referred to as Metal 1 or "M1") may be formed directly on the device layer 704. In some embodiments, the first interconnect layer 706 may include lines 728a and/or vias 728b, as shown. The lines 728a of the first interconnect layer 706 may be coupled with contacts (e.g., the S/D contacts 724) of the device layer 704. The vias 728b of the first interconnect layer 706 may be coupled with the lines 728a of a second interconnect layer 708.

The second interconnect layer 708 (referred to as Metal 2 or "M2") may be formed directly on the first interconnect layer 706. In some embodiments, the second interconnect layer 708 may include via 728b to couple the interconnect structures 728 of the second interconnect layer 708 with the lines 728a of a third interconnect layer 710. Although the lines 728a and the vias 728b are structurally delineated with a line within individual interconnect layers for the sake of clarity, the lines 728a and the vias 728b may be structurally and/or materially contiguous (e.g., simultaneously filled during a dual-damascene process) in some embodiments.

The third interconnect layer 710 (referred to as Metal 11 or "M3") (and additional interconnect layers, as desired) may be formed in succession on the second interconnect layer 708 according to similar techniques and configurations described in connection with the second interconnect layer 708 or the first interconnect layer 706. In some embodiments, the interconnect layers that are "higher up" in the metallization stack 719 in the integrated circuit device 700 (e.g., farther away from the device layer 704) may be thicker that the interconnect layers that are lower in the metallization stack 719, with lines 728a and vias 728b in the higher interconnect layers being thicker than those in the lower interconnect layers.

The integrated circuit device 700 may include a solder resist material 734 (e.g., polyimide or similar material) and one or more conductive contacts 736 formed on the interconnect layers 706-710. In FIG. 7, the conductive contacts 736 are illustrated as taking the form of bond pads. The conductive contacts 736 may be electrically coupled with the interconnect structures 728 and configured to route the electrical signals of the transistor(s) 740 to external devices. For example, solder bonds may be formed on the one or more conductive contacts 736 to mechanically and/or electrically couple an integrated circuit die including the integrated circuit device 700 with another component (e.g., a printed circuit board). The integrated circuit device 700 may include additional or alternate structures to route the electrical signals from the interconnect layers 706-710; for example, the conductive contacts 736 may include other analogous features (e.g., posts) that route the electrical signals to external components.

In some embodiments in which the integrated circuit device 700 is a double-sided die, the integrated circuit device 700 may include another metallization stack (not shown) on the opposite side of the device layer(s) 704. This metallization stack may include multiple interconnect layers as discussed above with reference to the interconnect layers 706-710, to provide conductive pathways (e.g., including conductive lines and vias) between the device layer(s) 704 and additional conductive contacts (not shown) on the opposite side of the integrated circuit device 700 from the conductive contacts 736.

In other embodiments in which the integrated circuit device 700 is a double-sided die, the integrated circuit device 700 may include one or more through silicon vias (TSVs) through the die substrate 702; these TSVs may make contact with the device layer(s) 704, and may provide conductive pathways between the device layer(s) 704 and additional conductive contacts (not shown) on the opposite side of the integrated circuit device 700 from the conductive contacts 736. In some embodiments, TSVs extending through the substrate can be used for routing power and ground signals from conductive contacts on the opposite side of the integrated circuit device 700 from the conductive contacts 736 to the transistors 740 and any other components integrated into the integrated circuit device (e.g., die) 700, and the metallization stack 719 can be used to route I/O signals from the conductive contacts 736 to transistors 740 and any other components integrated into the integrated circuit device (e.g., die) 700.

Multiple integrated circuit devices 700 may be stacked with one or more TSVs in the individual stacked devices providing connection between one of the devices to any of the other devices in the stack. For example, one or more high-bandwidth memory (HBM) integrated circuit dies can be stacked on top of a base integrated circuit die and TSVs in the HBM dies can provide connection between the individual HBM and the base integrated circuit die. Conductive contacts can provide additional connections between adjacent integrated circuit dies in the stack. In some embodiments, the conductive contacts can be fine-pitch solder bumps (microbumps).

FIGS. 8A-8D are simplified perspective views of example planar, FinFET, gate-all-around, and stacked gate-all-around transistors. The transistors illustrated in FIGS. 8A-8D are formed on a substrate 816 having a surface 808. Isolation regions 814 separate the source and drain regions of the transistors from other transistors and from a bulk region 818 of the substrate 816.

FIG. 8A is a perspective view of an example planar transistor 800 comprising a gate 802 that controls current flow between a source region 804 and a drain region 806. The transistor 800 is planar in that the source region 804 and the drain region 806 are planar with respect to the substrate surface 808.

FIG. 8B is a perspective view of an example FinFET transistor 820 comprising a gate 822 that controls current flow between a source region 824 and a drain region 826. The transistor 820 is non-planar in that the source region 824 and the drain region 826 comprise "fins" that extend upwards from the substrate surface 828. As the gate 822 encompasses three sides of the semiconductor fin that extends from the source region 824 to the drain region 826, the transistor 820 can be considered a tri-gate transistor. FIG. 8B illustrates one S/D fin extending through the gate 822, but multiple S/D fins can extend through the gate of a FinFET transistor.

FIG. 8C is a perspective view of a gate-all-around (GAA) transistor 840 comprising a gate 842 that controls current flow between a source region 844 and a drain region 846. The transistor 840 is non-planar in that the source region 844 and the drain region 846 are elevated from the substrate surface 828.

FIG. 8D is a perspective view of a GAA transistor 860 comprising a gate 862 that controls current flow between multiple elevated source regions 864 and multiple elevated drain regions 866. The transistor 860 is a stacked GAA transistor as the gate controls the flow of current between multiple elevated S/D regions stacked on top of each other. The transistors 840 and 860 are considered gate-all-around transistors as the gates encompass all sides of the semiconductor portions that extends from the source regions to the drain regions. The transistors 840 and 860 can alternatively be referred to as nanowire, nanosheet, or nanoribbon transistors depending on the width (e.g., widths 848 and 868 of transistors 840 and 860, respectively) of the semiconductor portions extending through the gate.

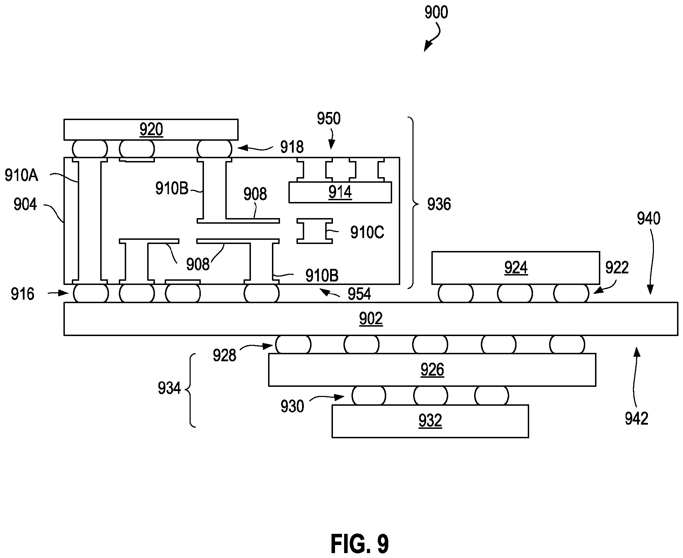

FIG. 9 is a cross-sectional side view of an integrated circuit device assembly 900 that may include one or more transistors comprising antimony and phosphorus doped epitaxial source/drain layers as described herein. The integrated circuit device assembly 900 includes a number of components disposed on a circuit board 902 (which may be a motherboard, system board, mainboard, etc.). The integrated circuit device assembly 900 includes components disposed on a first face 940 of the circuit board 902 and an opposing second face 942 of the circuit board 902; generally, components may be disposed on one or both faces 940 and 942.

In some embodiments, the circuit board 902 may be a printed circuit board (PCB) including multiple metal (or interconnect) layers separated from one another by layers of dielectric material and interconnected by electrically conductive vias. The individual metal layers comprise conductive traces. Any one or more of the metal layers may be formed in a desired circuit pattern to route electrical signals (optionally in conjunction with other metal layers) between the components coupled to the circuit board 902. In other embodiments, the circuit board 902 may be a non-PCB substrate. The integrated circuit device assembly 900 illustrated in FIG. 9 includes a package-on-interposer structure 936 coupled to the first face 940 of the circuit board 902 by coupling components 916. The coupling components 916 may electrically and mechanically couple the package-on-interposer structure 936 to the circuit board 902, and may include solder balls (as shown in FIG. 9), pins (e.g., as part of a pin grid array (PGA), contacts (e.g., as part of a land grid array (LGA)), male and female portions of a socket, an adhesive, an underfill material, and/or any other suitable electrical and/or mechanical coupling structure.

The package-on-interposer structure 936 may include an integrated circuit component 920 coupled to an interposer 904 by coupling components 918. The coupling components 918 may take any suitable form for the application, such as the forms discussed above with reference to the coupling components 916. Although a single integrated circuit component 920 is shown in FIG. 9, multiple integrated circuit components may be coupled to the interposer 904; indeed, additional interposers may be coupled to the interposer 904. The interposer 904 may provide an intervening substrate used to bridge the circuit board 902 and the integrated circuit component 920.

The integrated circuit component 920 may be a packaged or unpackaged integrated circuit product that includes one or more integrated circuit dies (e.g., the die 602 of FIG.2, the integrated circuit device 700 of FIG. 7) and/or one or more other suitable components. A packaged integrated circuit component comprises one or more integrated circuit dies mounted on a package substrate with the integrated circuit dies and package substrate encapsulated in a casing material, such as a metal, plastic, glass, or ceramic. In one example of an unpackaged integrated circuit component 920, a single monolithic integrated circuit die comprises solder bumps attached to contacts on the die. The solder bumps allow the die to be directly attached to the interposer 904. The integrated circuit component 920 can comprise one or more computing system components, such as one or more processor units (e.g., system-on-a-chip (SoC), processor core, graphics processor unit (GPU), accelerator, chipset processor), I/O controller, memory, or network interface controller. In some embodiments, the integrated circuit component 920 can comprise one or more additional active or passive devices such as capacitors, decoupling capacitors, resistors, inductors, fuses, diodes, transformers, sensors, electrostatic discharge (ESD) devices, and memory devices.

In embodiments where the integrated circuit component 920 comprises multiple integrated circuit dies, the dies can be of the same type (a homogeneous multi-die integrated circuit component) or of two or more different types (a heterogeneous multi-die integrated circuit component). A multi-die integrated circuit component can be referred to as a multi-chip package (MCP) or multi-chip module (MCM).

In addition to comprising one or more processor units, the integrated circuit component 920 can comprise additional components, such as embedded DRAM, stacked high bandwidth memory (HBM), shared cache memories, input/output (I/O) controllers, or memory controllers. Any of these additional components can be located on the same integrated circuit die as a processor unit, or on one or more integrated circuit dies separate from the integrated circuit dies comprising the processor units. These separate integrated circuit dies can be referred to as "chiplets". In embodiments where an integrated circuit component comprises multiple integrated circuit dies, interconnections between dies can be provided by the package substrate, one or more silicon interposers, one or more silicon bridges embedded in the package substrate (such as Intel^{®} embedded multi-die interconnect bridges (EMIBs)), or combinations thereof.

Generally, the interposer 904 may spread connections to a wider pitch or reroute a connection to a different connection. For example, the interposer 904 may couple the integrated circuit component 920 to a set of ball grid array (BGA) conductive contacts of the coupling components 916 for coupling to the circuit board 902. In the embodiment illustrated in FIG. 9, the integrated circuit component 920 and the circuit board 902 are attached to opposing sides of the interposer 904; in other embodiments, the integrated circuit component 920 and the circuit board 902 may be attached to a same side of the interposer 904. In some embodiments, three or more components may be interconnected by way of the interposer 904.

In some embodiments, the interposer 904 may be formed as a PCB, including multiple metal layers separated from one another by layers of dielectric material and interconnected by electrically conductive vias. In some embodiments, the interposer 904 may be formed of an epoxy resin, a fiberglass-reinforced epoxy resin, an epoxy resin with inorganic fillers, a ceramic material, or a polymer material such as polyimide. In some embodiments, the interposer 904 may be formed of alternate rigid or flexible materials that may include the same materials described above for use in a semiconductor substrate, such as silicon, germanium, and other group III-V and group IV materials. The interposer 904 may include metal interconnects 908 and vias 910, including but not limited to through hole vias 910-1 (that extend from a first face 950 of the interposer 904 to a second face 954 of the interposer 904), blind vias 910-2 (that extend from the first or second faces 950 or 954 of the interposer 904 to an internal metal layer), and buried vias 910-3 (that connect internal metal layers).

In some embodiments, the interposer 904 can comprise a silicon interposer. Through silicon vias (TSV) extending through the silicon interposer can connect connections on a first face of a silicon interposer to an opposing second face of the silicon interposer. In some embodiments, an interposer 904 comprising a silicon interposer can further comprise one or more routing layers to route connections on a first face of the interposer 904 to an opposing second face of the interposer 904.

The interposer 904 may further include embedded devices 914, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 904. The package-on-interposer structure 936 may take the form of any of the package-on-interposer structures known in the art.

The integrated circuit device assembly 900 may include an integrated circuit component 924 coupled to the first face 940 of the circuit board 902 by coupling components 922. The coupling components 922 may take the form of any of the embodiments discussed above with reference to the coupling components 916, and the integrated circuit component 924 may take the form of any of the embodiments discussed above with reference to the integrated circuit component 920.

The integrated circuit device assembly 900 illustrated in FIG. 9 includes a package-on-package structure 934 coupled to the second face 942 of the circuit board 902 by coupling components 928. The package-on-package structure 934 may include an integrated circuit component 926 and an integrated circuit component 932 coupled together by coupling components 930 such that the integrated circuit component 926 is disposed between the circuit board 902 and the integrated circuit component 932. The coupling components 928 and 930 may take the form of any of the embodiments of the coupling components 916 discussed above, and the integrated circuit components 926 and 932 may take the form of any of the embodiments of the integrated circuit component 920 discussed above. The package-on-package structure 934 may be configured in accordance with any of the package-on-package structures known in the art.

FIG. 10 is a block diagram of an example electrical device 1000 that may include one or more transistors comprising antimony and phosphorus doped epitaxial source/drain layers as described herein. For example, any suitable ones of the components of the electrical device 1000 may include one or more of the integrated circuit dies 602, integrated circuit devices 700, integrated circuit device assemblies 900, integrated circuit components 920, or other components disclosed herein. A number of components are illustrated in FIG. 10 as included in the electrical device 1000, but any one or more of these components may be omitted or duplicated, as suitable for the application. In some embodiments, some or all of the components included in the electrical device 1000 may be attached to one or more motherboards mainboards, or system boards. In some embodiments, one or more of these components are fabricated onto a single system-on-a-chip (SoC) die.

Additionally, in various embodiments, the electrical device 1000 may not include one or more of the components illustrated in FIG. 10, but the electrical device 1000 may include interface circuitry for coupling to the one or more components. For example, the electrical device 1000 may not include a display device 1006, but may include display device interface circuitry (e.g., a connector and driver circuitry) to which a display device 1006 may be coupled. In another set of examples, the electrical device 1000 may not include an audio input device 1024 or an audio output device 1008, but may include audio input or output device interface circuitry (e.g., connectors and supporting circuitry) to which an audio input device 1024 or audio output device 1008 may be coupled.

The electrical device 1000 may include one or more processor units 1002 (e.g., one or more processor units). As used herein, the terms "processor unit", "processing unit" or "processor" may refer to any device or portion of a device that processes electronic data from registers and/or memory to transform that electronic data into other electronic data that may be stored in registers and/or memory. The processor unit 1002 may include one or more digital signal processors (DSPs), application-specific integrated circuits (ASICs), central processing units (CPUs), graphics processing units (GPUs), general-purpose GPUs (GPGPUs), accelerated processing units (APUs), field-programmable gate arrays (FPGAs), neural network processing units (NPUs), data processor units (DPUs), accelerators (e.g., graphics accelerator, compression accelerator, artificial intelligence accelerator), controller cryptoprocessors (specialized processors that execute cryptographic algorithms within hardware), server processors, controllers, or any other suitable type of processor units. As such, the processor unit can be referred to as an XPU (or xPU).

The electrical device 1000 may include a memory 1004, which may itself include one or more memory devices such as volatile memory (e.g., dynamic random access memory (DRAM), static random-access memory (SRAM)), non-volatile memory (e.g., read-only memory (ROM), flash memory, chalcogenide-based phase-change non-voltage memories), solid state memory, and/or a hard drive. In some embodiments, the memory 1004 may include memory that is located on the same integrated circuit die as the processor unit 1002. This memory may be used as cache memory (e.g., Level 1 (L1), Level 2 (L2), Level 3 (L3), Level 4 (L4), Last Level Cache (LLC)) and may include embedded dynamic random access memory (eDRAM) or spin transfer torque magnetic random access memory (STT-MRAM).

In some embodiments, the electrical device 1000 can comprise one or more processor units 1002 that are heterogeneous or asymmetric to another processor unit 1002 in the electrical device 1000. There can be a variety of differences between the processing units 1002 in a system in terms of a spectrum of metrics of merit including architectural, microarchitectural, thermal, power consumption characteristics, and the like. These differences can effectively manifest themselves as asymmetry and heterogeneity among the processor units 1002 in the electrical device 1000.

In some embodiments, the electrical device 1000 may include a communication component 1012 (e.g., one or more communication components). For example, the communication component 1012 can manage wireless communications for the transfer of data to and from the electrical device 1000. The term "wireless" and its derivatives may be used to describe circuits, devices, systems, methods, techniques, communications channels, etc., that may communicate data through the use of modulated electromagnetic radiation through a nonsolid medium. The term "wireless" does not imply that the associated devices do not contain any wires, although in some embodiments they might not.

The communication component 1012 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication component 1012 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication component 1012 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication component 1012 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication component 1012 may operate in accordance with other wireless protocols in other embodiments. The electrical device 1000 may include an antenna 1022 to facilitate wireless communications and/or to receive other wireless communications (such as amplitude modulation (AM) or frequency modulation (FM) radio transmissions).

In some embodiments, the communication component 1012 may manage wired communications, such as electrical, optical, or any other suitable communication protocols (e.g., IEEE 802.3 Ethernet standards). As noted above, the communication component 1012 may include multiple communication components. For instance, a first communication component 1012 may be dedicated to shorter-range wireless communications such as Wi-Fi or Bluetooth, and a second communication component 1012 may be dedicated to longer-range wireless communications such as global positioning system (GPS), EDGE, GPRS, CDMA, WiMAX, LTE, EV-DO, or others. In some embodiments, a first communication component 1012 may be dedicated to wireless communications, and a second communication component 1012 may be dedicated to wired communications.

The electrical device 1000 may include battery/power circuitry 1014. The battery/power circuitry 1014 may include one or more energy storage devices (e.g., batteries or capacitors) and/or circuitry for coupling components of the electrical device 1000 to an energy source separate from the electrical device 1000 (e.g., AC line power).

The electrical device 1000 may include a display device 1006 (or corresponding interface circuitry, as discussed above). The display device 1006 may include one or more embedded or wired or wirelessly connected external visual indicators, such as a heads-up display, a computer monitor, a projector, a touchscreen display, a liquid crystal display (LCD), a light-emitting diode display, or a flat panel display.

The electrical device 1000 may include an audio output device 1008 (or corresponding interface circuitry, as discussed above). The audio output device 1008 may include any embedded or wired or wirelessly connected external device that generates an audible indicator, such speakers, headsets, or earbuds.

The electrical device 1000 may include an audio input device 1024 (or corresponding interface circuitry, as discussed above). The audio input device 1024 may include any embedded or wired or wirelessly connected device that generates a signal representative of a sound, such as microphones, microphone arrays, or digital instruments (e.g., instruments having a musical instrument digital interface (MIDI) output). The electrical device 1000 may include a Global Navigation Satellite System (GNSS) device 1018 (or corresponding interface circuitry, as discussed above), such as a Global Positioning System (GPS) device. The GNSS device 1018 may be in communication with a satellite-based system and may determine a geolocation of the electrical device 1000 based on information received from one or more GNSS satellites, as known in the art.

The electrical device 1000 may include another output device 1010 (or corresponding interface circuitry, as discussed above). Examples of the other output device 1010 may include an audio codec, a video codec, a printer, a wired or wireless transmitter for providing information to other devices, or an additional storage device.

The electrical device 1000 may include another input device 1020 (or corresponding interface circuitry, as discussed above). Examples of the other input device 1020 may include an accelerometer, a gyroscope, a compass, an image capture device (e.g., monoscopic or stereoscopic camera), a trackball, a trackpad, a touchpad, a keyboard, a cursor control device such as a mouse, a stylus, a touchscreen, proximity sensor, microphone, a bar code reader, a Quick Response (QR) code reader, electrocardiogram (ECG) sensor, PPG (photoplethysmogram) sensor, galvanic skin response sensor, any other sensor, or a radio frequency identification (RFID) reader.

The electrical device 1000 may have any desired form factor, such as a hand-held or mobile electrical device (e.g., a cell phone, a smart phone, a mobile internet device, a music player, a tablet computer, a laptop computer, a 2-in-1 convertible computer, a portable all-in-one computer, a netbook computer, an ultrabook computer, a personal digital assistant (PDA), an ultra-mobile personal computer, a portable gaming console, etc.), a desktop electrical device, a server, a rack-level computing solution (e.g., blade, tray or sled computing systems), a workstation or other networked computing component, a printer, a scanner, a monitor, a set-top box, an entertainment control unit, a stationary gaming console, smart television, a vehicle control unit, a digital camera, a digital video recorder, a wearable electrical device or an embedded computing system (e.g., computing systems that are part of a vehicle, smart home appliance, consumer electronics product or equipment, manufacturing equipment). In some embodiments, the electrical device 1000 may be any other electronic device that processes data. In some embodiments, the electrical device 1000 may comprise multiple discrete physical components. Given the range of devices that the electrical device 1000 can be manifested as in various embodiments, in some embodiments, the electrical device 1000 can be referred to as a computing device or a computing system.

Throughout this specification, plural instances may implement components, operations, or structures described as a single instance. Although individual operations of one or more methods are illustrated and described as separate operations, one or more of the individual operations may be performed concurrently, and nothing requires that the operations be performed in the order illustrated. Structures and functionality presented as separate components in example configurations may be implemented as a combined structure or component. Similarly, structures and functionality presented as a single component may be implemented as separate components. These and other variations, modifications, additions, and improvements fall within the scope of the subject matter herein.

It will also be understood that, although the terms "first," "second," and so forth may be used herein to describe various elements, these elements should not be limited by these terms. These terms are only used to distinguish one element from another, and are not intended to imply that the objects so described must be in a given sequence, either temporally, spatially, in ranking or in any other manner. For example, a first contact could be termed a second contact, and, similarly, a second contact could be termed a first contact, without departing from the scope of the present example embodiments. The first contact and the second contact are both contacts, but they are not the same contact.

As used in the description of the example embodiments and the appended examples, the singular forms "a," "an," and "the" are intended to include the plural forms as well, unless the context clearly indicates otherwise. It will also be understood that the term "and/or" as used herein refers to and encompasses any and all possible combinations of one or more of the associated listed items. For example, the phrase "A and/or B" means (A), (B), or (A and B), while the phrase "A, B, and/or C" means (A), (B), (C), (A and B), (A and C), (B and C), or (A, B, and C).

As used throughout this description, and in the claims, a list of items joined by the term "at least one of" or "one or more of" can mean any combination of the listed terms.

It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. Furthermore, the terms "comprising," "including," "having," and the like, as used with respect to embodiments of the present disclosure, are synonymous.

The description may use the phrases "in an embodiment," "according to some embodiments," "in accordance with embodiments," or "in embodiments," which may each refer to one or more of the same or different embodiments.

As used herein, the term "module" refers to being part of, or including an ASIC, an electronic circuit, a system on a chip, a processor (shared, dedicated, or group), a solid state device, a memory (shared, dedicated, or group) that execute one or more software or firmware programs, a combinational logic circuit, and/or other suitable components that provide the described functionality.

As used herein, "electrically conductive" in some examples may refer to a property of a material having an electrical conductivity greater than or equal to 107 Siemens per meter (S/m) at 20 degrees Celsius. Examples of such materials include Cu, Ag, Al, Au, W, Zn and Ni.

The term "signal" may refer to at least one current signal, voltage signal, magnetic signal, or data/clock signal.

Throughout the specification, and in the claims, the term "connected" means a direct connection, such as electrical, mechanical, or magnetic connection between the elements that are connected, without any intermediary devices. The term "coupled" means a direct or indirect connection, such as a direct electrical, mechanical, or magnetic connection between the elements that are connected or an indirect connection, through one or more passive or active intermediary devices.

The description may use perspective-based descriptions such as top/bottom, in/out, over/under, and the like. Such descriptions are merely used to facilitate the discussion and are not intended to restrict the application of embodiments described herein to any particular orientation.

The terms "over," "under," "between," and "on" as used herein refer to a relative position of one component or material with respect to other components or materials where such physical relationships are noteworthy. For example, in the context of materials, one material or layer over or under another may be directly in contact or may have one or more intervening materials or layers. Moreover, one material between two materials or layers may be directly in contact with the two materials/layers or may have one or more intervening materials/layers. In contrast, a first material or layer "on" a second material or layer means that at least a part of the first material or layer is in direct physical contact with at least a part of that second material/layer. Similar distinctions are to be made in the context of component assemblies.

As used herein, "A is adjacent to B" means that at least part of A is in direct physical contact with at least a part of B.

As used herein, "A is proximate to B" may mean that A is adjacent to B or A is otherwise near to B.

Unless otherwise specified in the specific context of use, the term "predominantly" means more than 50%, or more than half. For example, a composition that is predominantly a first constituent means more than half of the composition (e.g., by volume) is the first constituent (e.g., >50 at. %). The term "primarily" means the most, or greatest, part. For example, a composition that is primarily a first constituent means the composition has more of the first constituent (e.g., by volume) than any other constituent. A composition that is primarily first and second constituents means the composition has more of the first and second constituents than any other constituent. The term "substantially" means there is only incidental variation. For example, composition that is substantially a first constituent means the composition may further include <1% of any other constituent. A composition that is substantially first and second constituents means the composition may further include <1% of any constituent substituted for either the first or second constituent.

The terms "substantially," "close," "approximately," "near," and "about," generally refer to being within +/- 10% of a target value (unless specifically specified).

Unless otherwise specified in the explicit context of their use, the terms "substantially equal," "about equal" or "approximately equal" mean that there is no more than incidental variation between two things so described. In the art, such variation is typically no more than +/-10% of a predetermined target value.

In the corresponding drawings of the embodiments, signals, currents, electrical biases, or magnetic or electrical polarities may be represented with lines. Some lines may be thicker, to indicate more constituent signal paths, and/or have arrows at one or more ends, to indicate primary information flow direction. Such indications are not intended to be limiting. Rather, the lines are used in connection with one or more exemplary embodiments to facilitate easier understanding of a circuit or a logical unit. Any represented signal, polarity, current, voltage, etc., as dictated by design needs or preferences, may actually comprise one or more signals that may travel in either direction and may be implemented with any suitable type of signal scheme.

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements.

Although the figures may illustrate embodiments where structures are substantially aligned to Cartesian axes (e.g., device structures having substantially vertical sidewalls), positive and negative (re-entrant) sloped feature sidewalls often occur in practice. For example, manufacturing non-idealities may cause one or more structural features to have sloped sidewalls. Thus, attributes illustrated are idealized merely for the sake of clearly describing salient features. It is to be understood that schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication.

Example 1 includes an apparatus, comprising a channel material of an n-type transistor; a first layer of a source or drain region of the n-type transistor, the first layer in contact with the channel material, the first layer comprising antimony and silicon; and a second layer of the source or drain region of the n-type transistor, the second layer in contact with the first layer, the second layer comprising phosphorus and silicon.

Example 2 includes the subject matter of Example 1, and wherein the first layer further comprises phosphorus.

Example 3 includes the subject matter of any of Examples 1 and 2, and wherein a concentration of antimony in the first layer is within a range of 3E20 up to 2E21 atoms/cm3.

Example 4 includes the subject matter of any of Examples 1-3, and wherein a maximum thickness of the first layer is between 2 and 7 nanometers.

Example 5 includes the subject matter of any of Examples 1-4, and wherein a concentration of antimony in the first layer is approximately 5E20 atoms/cm3.

Example 6 includes the subject matter of any of Examples 1-5, and further including a contact metal, wherein the second layer is in between the contact metal and the channel material.

Example 7 includes the subject matter of any of Examples 1-6, and further including a third layer between the second layer and the contact metal, the third layer comprising at least one of titanium, nickel, or platinum.

Example 8 includes the subject matter of any of Examples 1-7, and wherein the apparatus is an integrated circuit component.

Example 9 includes the subject matter of any of Examples 1-8, and wherein the apparatus further comprises a printed circuit board; and a first integrated circuit component attached to the printed circuit board, the first integrated circuit component comprising the channel material, the first layer, and the second layer.

Example 10 includes the subject matter of any of Examples 1-9, wherein the apparatus further comprises one or more second integrated circuit components attached to the printed circuit board.

Example 11 includes an apparatus, comprising a channel material; a contact metal; a first layer between the channel material and the contact metal, the first layer comprising antimony and silicon; and a second layer between the contact metal and the first layer, the second layer comprising phosphorus and silicon.

Example 12 includes the subject matter of Example 11, and wherein the first layer further comprises phosphorus.

Example 13 includes the subject matter of any of Examples 11 and 12, and wherein a concentration of antimony in the first layer is within a range of 3E20 up to 2E21 atoms/cm3.

Example 14 includes the subject matter of any of Examples 11-13, and wherein a maximum thickness of the first layer is between 2 and 7 nanometers.

Example 15 includes the subject matter of any of Examples 11-14, and wherein a concentration of antimony in the first layer is approximately 5E20 atoms/cm3.

Example 16 includes the subject matter of any of Examples 11-15, and further including a third layer between the second layer and the contact metal, the third layer comprising at least one of titanium, nickel, or platinum.

Example 17 includes the subject matter of any of Examples 11-16, and wherein the apparatus is an integrated circuit component.

Example 18 includes the subject matter of any of Examples 11-17, and wherein the apparatus further comprises a printed circuit board; and a first integrated circuit component attached to the printed circuit board, the first integrated circuit component comprising the channel material, the first layer, and the second layer.

Example 19 includes the subject matter of any of Examples 11-18, wherein the apparatus further comprises one or more second integrated circuit components attached to the printed circuit board.

Example 20 includes a method, comprising forming a channel material; forming a first layer adjacent to the channel material, the first layer comprising silicon and antimony; and forming a second layer adjacent to the first layer, the second layer comprising silicon and phosphorus.

Example 21 includes the subject matter of Example 20, and wherein forming the first layer comprises applying a precursor gas comprising trimethyl antimony, triethyl antimony, or antimony pentachloride.

Example 22 includes the subject matter of any of Examples 20 and 21, and wherein forming the first layer comprises applying the precursor gas at a temperature within a range of 600 to 750 degrees Celsius.

Example 23 includes the subject matter of any of Examples 20-22, and wherein forming the first layer further comprises applying a second precursor gas comprising phosphene.

Example 24 includes the subject matter of any of Examples 20-23, and wherein a concentration of antimony in the first layer is within a range of 3E20 up to 2E21 atoms/cm3.

Example 25 includes the subject matter of any of Examples 20-24, and wherein the first layer further comprises phosphorus.

Example 26 includes the subject matter of any of Examples 20-25, and wherein a maximum thickness of the first layer is between 2 and 7 nanometers.

Example 27 includes the subject matter of any of Examples 20-26, and wherein a concentration of antimony in the first layer is approximately 5E20 atoms/cm3.

Example 28 includes the subject matter of any of Examples 20-27, and further including forming a contact metal and a third layer between the second layer and the contact metal, the third layer comprising at least one of titanium, nickel, or platinum.

Example 29 includes the subject matter of any of Examples 20-28, and wherein the method further comprises coupling a first integrated circuit component to a printed circuit board, the first integrated circuit component comprising the channel material, the first layer, and the second layer.

Example 30 includes the subject matter of any of Examples 20-29, and wherein the method further comprises attaching one or more second integrated circuit components to the printed circuit board.

Example 31 includes a method, comprising forming a channel material of an n-type transistor; forming a first layer of a source or drain region of the n-type transistor, the first layer in contact with the channel material, the first layer comprising antimony and silicon; and forming a second layer of the source or drain region of the n-type transistor, the second layer in contact with the first layer, the second layer comprising phosphorus and silicon.

Example 32 includes the subject matter of Example 31, and wherein the first layer further comprises phosphorus.

Example 33 includes the subject matter of any of Examples 31 and 32, and wherein a concentration of antimony in the first layer is within a range of 3E20 up to 2E21 atoms/cm3.

Example 34 includes the subject matter of any of Examples 31-33, and wherein a maximum thickness of the first layer is between 2 and 7 nanometers.

Example 35 includes the subject matter of any of Examples 31-34, and wherein a concentration of antimony in the first layer is approximately 5E20 atoms/cm3.

Example 36 includes the subject matter of any of Examples 31-35, and further including forming a contact metal, wherein the second layer is in between the contact metal and the channel material.

Example 37 includes the subject matter of any of Examples 31-36, and further including forming a third layer between the second layer and the contact metal, the third layer comprising at least one of titanium, nickel, or platinum.

The foregoing description, for the purpose of explanation, has been described with reference to specific example embodiments. However, the illustrative discussions above are not intended to be exhaustive or to limit the possible example embodiments to the precise forms disclosed. Many modifications and variations are possible in view of the above teachings. The example embodiments were chosen and described in order to best explain the principles involved and their practical applications, to thereby enable others skilled in the art to best utilize the various example embodiments with various modifications as are suited to the particular use contemplated.

## Claims

1. An apparatus, comprising:
a channel material of an n-type transistor;
a first layer of a source or drain region of the n-type transistor, the first layer in contact with the channel material, the first layer comprising antimony and silicon; and
a second layer of the source or drain region of the n-type transistor, the second layer in contact with the first layer, the second layer comprising phosphorus and silicon.

2. The apparatus of claim 1, wherein the first layer further comprises phosphorus.

3. The apparatus of any one of claims 1-2, wherein a concentration of antimony in the first layer is within a range of 3E20 up to 2E21 atoms/cm³.

4. The apparatus of any one of claims 1-3, wherein a maximum thickness of the first layer is between 2 and 7 nanometers.

5. The apparatus of any one of claims 1-4, wherein a concentration of antimony in the first layer is approximately 5E20 atoms/cm³.

6. The apparatus of any one of claims 1-5, further comprising a contact metal, wherein the second layer is in between the contact metal and the channel material.

7. The apparatus of claim 6, further comprising a third layer between the second layer and the contact metal, the third layer comprising at least one of titanium, nickel, or platinum.

8. The apparatus of any one of claims 1-7, wherein the apparatus is an integrated circuit component.

9. The apparatus of any one of claims 1-8, wherein the apparatus further comprises:
a printed circuit board; and
a first integrated circuit component attached to the printed circuit board, the first integrated circuit component comprising the channel material, the first layer, and the second layer.

10. The apparatus of claim 9, wherein the apparatus further comprises one or more second integrated circuit components attached to the printed circuit board.

11. A method, comprising:
forming a channel material;
forming a first layer adjacent to the channel material, the first layer comprising silicon and antimony; and
forming a second layer adjacent to the first layer, the second layer comprising silicon and phosphorus.

12. The method of claim 11, wherein forming the first layer comprises applying a precursor gas comprising trimethyl antimony, triethyl antimony, or antimony pentachloride.

13. The method of claim 12, wherein forming the first layer comprises applying the precursor gas at a temperature within a range of 600 to 750 degrees Celsius.

14. The method of any one of claims 12-13, wherein forming the first layer further comprises applying a second precursor gas comprising phosphene.

15. The method of any one of claims 11-14, wherein a concentration of antimony in the second layer is within a range of 3E20 up to 2E21 atoms/cm³.
